# EUROPEAN PATENT SPECIFICATION

(11) **EP 3 499 548 B1**
(45) Date of publication and mention of the grant of the patent: **31.01.2024**
(21) Application number: 17839309.6
(22) Date of filing: 02.08.2017
(51) Int. Cl.: H01L 21/31, B24C 1/08, B24C 11/00, C23C 16/44

(54) **DEPOSIT REMOVING METHOD**
ABLAGERUNGENTFERNUNGSVERFAHREN
PROCÉDÉ DE RETRAIT DE DÉPÔTS

(30) Priority: 09.08.2016 JP 2016156245; 17.03.2017 JP 2017052219; 17.03.2017 JP 2017052220
(43) Date of publication of application: 19.06.2019
(73) Proprietor: Sintokogio, Ltd., Nagoya-shi, Aichi 450-6424 (JP)
(72) Inventor: NISHIJIMA Hitoshi, Ama-gun Aichi 490-1144 (JP); SHIBUYA Norihito, Ama-gun Aichi 490-1144 (JP)
(74) Representative: Müller-Boré & Partner Patentanwälte PartG mbB
(86) International application number: PCT/JP2017/028071
(87) International publication number: WO 2018/030236

(56) References cited:
- JP-A- 2003 073 832
- JP-A- 2004 358 312
- JP-A- 2011 108 749
- JP-A- 2014 097 566
- JP-A- 2016 068 188
- JP-A- 2016 068 188
- US-A- 5 308 404
- US-A1- 2011 139 308

## Description

### Technical Field

0001 The present invention pertains to an adhered object removal method.

### Background Art

0002 Previously, a deposition process achieved by thin film crystal growth (referred to below as "deposition process" below unless otherwise noted) has been used in the manufacture of semiconductor devices and the manufacture of tools and jigs on which hard films are formed. A film-forming material adheres to the jigs used in these deposition processes. Because these adhered objects pose a risk of degradation of product properties, there is a need to regularly remove such adhered objects.

0003 For example, a deposition device used in a semiconductor device manufacturing process comprises fixtures such as a tray for mounting a wafer to be processed, a susceptor for holding the processed object in a predetermined position on a tray, and an opposing plate, disposed to oppose the susceptor, for controlling the flow of gas within a chamber. Such jigs are formed with consideration for usage conditions such as temperature and atmosphere. For example, an opposing plate, tray, and susceptor are formed of quartz or SiC or carbon coated with SiC.

0004 Conceivable methods for removing objects adhered to such jigs are chemical etching (e.g., Patent Documents 1 and 2), plasma etching (Patent Document 3), and blast treatment (Patent Document 4).

0005 Patent Document 1 discloses a method for dissolving and removing adhered objects by submersing a silicon-carbide jig 10 for semiconductor device manufacturing in a 10% or greater by volume nitro-hydrochloric acid solution or fluoronitric acid solution for 30 minutes or more. Patent Document 2 discloses a method for removing hard coatings whereby abrasive grains of greater hardness than the hard coating are blasted onto surfaces on which a hard coating such as TiN and TiCN are formed, thereby removing the hard coating. Because the Patent Document 1 method uses acid, care is required from both an occupational and environmental standpoint. Also, because many hours are required to remove hard coatings, work efficiency is poor, and since chemical fluids must be processed after use, the process is uneconomical. Further, because jigs are submerged in chemical fluids, a large submersion vessel and large volumes of chemical fluid are required. In addition, when removing adhered objects attached to carbon surfaces coated with SiC, the chemical fluid also penetrates into the carbon. Removing this requires long drying periods.

0006 Patent Document 2 discloses a method for removing contaminants on parts constituting a semiconductor fabrication apparatus by bringing the contaminant into contact with a chlorine-based gas. Because the Patent Document 2 method uses acid, care is required from both an occupational and environmental standpoint.

0007 Patent Document 3 discloses a method for combustion removal of objects adhered to the surface of individual magnetic transfer masters by plasma etching. Application of the method of Patent Document 3 as is for the removal of adhered objects adhered to a jig may conceivably produce damage to the jig by plasma discharge. In addition, this work is conducted under a vacuum, leading to poor workability and a requirement for large scale equipment.

0008 Patent Document 4 discloses a method for removing hard coatings whereby abrasive granules of greater hardness than the hard coating are blasted onto surfaces on which hard coatings such as TIN and TiCN are formed, thereby removing the hard coating. When adhered objects are removed by the method of Patent Document 4, jigs generally used in the deposition process are suddenly exposed to very strong process conditions when the hard adhered objects are removed. This results in major damage to the surface of the jig.

Patent Document 5 discloses an adhered object removal method for removing adhered objects from CVD equipment, used in film deposition processes accomplished by thin film crystal growth, comprising:
- preparing a jetting media having a lower hardness than the hardness of the CVD equipment; and
- jetting the jetting media toward the CVD equipment,

whereby in the jetting, the jetting media (dry ice) forms fracture starting points at a crystal grain boundary of the adhered object when the jetting media collides with the CVD equipment, and the jetting media collides with the fracture starting points and causes the adhered objects to dislodge at the crystal grain boundary,
whereby the jetting media does not contain a metal component, and adhered objects are removed by collision energy when the jetting media jetted toward the CVD equipment collides with the CVD equipment.

### Prior Art References

### Patent Documents

0009
Patent Document 1: Japanese Published Unexamined Patent Application H08-078375
Patent Document 2: Japanese Published Unexamined Patent Application 2006-332201
Patent Document 3: Japanese Published Unexamined Patent Application 2003-085936
Patent Document 4: Japanese Published Unexamined Patent Application 2006-305694
Patent Document 5: US 5 308 404 A

### Summary of the Invention

### Problems the Invention Seeks to Resolve

0010 In light of the above, the present invention is an adhered object removal method for removing adhered objects adhering to jigs in the deposition process, with the object of providing an adhered object removal method capable of reducing jig damage and efficiently removing hard adhered objects.

### Means for Resolving Problem

0011 The claimed invention is defined in independent claim 1. Specific embodiments are defined in the depend claims.

0012 In conventional methods for removing adhered objects by blasting with a granular jet material or the like, such as the invention of Patent Document 4, the general practice was to use a jet material with a higher hardness than the adhered objects to be removed in order to eliminate adhered objects. However, whereas the jigs used in deposition processes using thin film crystal growth are relatively soft, coatings adhering to them have high hardness. Therefore when high-hardness adhered objects adhering to the surface of jigs presenting a soft processing surface are removed by blasting with a blasting material which is still harder than the adhered object, the processed surface is badly damaged. I.e., when adhered objects adhered to a jig are removed by blasting material, blasting of the blasting material is continued even when part of the adhered objects have been removed and a portion of the jig surface is exposed, thereby causing the soft jig surface to be damaged. This type of problem is a technical issue inherent to the removal of adhered objects from jigs used in deposition processes using thin film crystal growth, in which hard adhered objects adhere to soft processing surfaces.

0013 The present inventors discovered that adhered objects adhering to jigs used in deposition processes can also be removed by jetting with a jetting media of a lower hardness than the jig. According to the claimed invention, adhered objects adhere to a jig are removed by jetting with a jetting media of a lower hardness than the jig, therefore adhered objects can be removed while preventing damage to the jig. In the jetting stage, the jetting media forms the starting point for fracture at the crystal grain boundary of the adhered objects when it hits the jig, and the jetting media upon collision with a fracture starting point is able to dislodge the adhered objects. According to the claimed invention the jetting media does not contain a metal component, and adhered objects are removed by collision energy when the jetting media jetted toward the jig collides with the jig.
By using a jetting media with a lower hardness than the jig, the jetting media is able to remove adhered objects without damaging the jig itself, even though it collides with the jig. In addition, since a substance containing no metal component is used as the jetting media, no metal component remains on the jig. I.e., processing can be performed whereby adhered objects are removed without damaging the jig itself, and no metal component, which causes a drop in the quality of the coating, is left during deposition.

According to the claimed invention, it is acceptable for at least the surface layer of the jetting media to consist of resin. A resin material contains no metal component, and is furthermore a soft material, therefore it can satisfy both the need to leave no metal component on the jig, and the need remove adhered objects without damaging the jig.

0015 In a deposition process using thin film crystal growth, a large number of fine crystals(crystal grains) are first formed; these crystal grains then each grow to become a polycrystalline body. Therefore a discontinuous boundary surface (crystal boundary) remains between the crystals. According to the adhered object removal method of the present invention, when adhered objects have adhered in a thin film process using thin film crystal growth, a fracture starting point is formed at the adhered object crystal grain boundary by collision of the jetting media, and the jetting media is able to dislodge the adhered objects at the crystal grain boundary upon hitting the fracture starting point, therefore adhered objects can be remove even if the jetting media has a lower hardness than the jig. I.e., this adhered object removal method is a new adhered object removal method, different from conventional methods in which adhered objects were removed by causing jetting media to collide so as to remove the adhered objects. A jetting media with a lower hardness than the jig is used, and the collision force thereof is of an order to create fracture starting points at the crystal grain boundary, therefore collisions with the jig can be minimized. Also, adhered objects can be removed from a jig simply by jetting with jetting media onto the jig, therefore adhered objects can be removed in a simple and quick manner. I.e., damage to jigs can be reduced, and hard adhered objects can be efficiently removed. In addition, locations such as those where adhered objects are strongly adhered or corners or the like of three-dimensional objects where one wishes to focus removal work can be freely selected.

Jigs include not only those formed of single materials such as quartz or SiC as discussed above, but also those formed of composite materials such as carbon, with an SiC coating layer, as discussed above.

0016 In one embodiment, the hardness of the jetting media may be 1/2 or less of the jig hardness. In the process of removing adhered objects, the jig is damaged if the jig surface is exposed due to a portion of the adhered objects peeling, so that jetting media collides with the exposed surface. Both the requirement to remove adhered objects and the requirement to suppress damage to the jig can be satisfied.

0017 In one embodiment, the adhered objects may also be harder than the jig. Significant damage to the jig is prone to occur when removing adhered objects harder than the jig, but by using the above-described adhered object removal method, damage to the jig is reduced, and hard adhered objects can be efficiently removed.

0018 In one embodiment, adhered objects adhering to a jig with a Vickers hardness within the range of HV100 to HV918 can be removed. Removal of adhered objects may also be accomplished by colliding jetting media with a Rockwell hardness within the range of R15 to R125 or within the range of M20 to M125 into a jig at a collision energy within the range of 1.0 × 10⁻⁹J to 1.0 × 10⁻⁸J. By selecting a collision energy within this range, a fracture starting point can be formed at the crystal grain boundary without imparting damage to the jig, and damage to the jig can also be removed in subsequent collisions. Therefore, jig damage can be minimized, and adhered objects can be efficiently removed.

0019 In one embodiment, adhered objects adhering to the coating layer may also be removed from jigs having a ceramic coating layer. Removal of adhered objects may also be accomplished by colliding jetting media with a Young's modulus of 50GPa or greater into a jig at a collision energy within the range of 1.0 × 10⁻⁹J to 1.0 × 10⁻⁸J. Adhered objects can be removed without loss of the coating layer.

0020 In one embodiment, the jetting media has corner portions. The corner portions can promote fracture of the crystal grain boundary when they make contact with adhered objects.

0021 In one embodiment, the jetting media may be of approximately the same material as the adhered objects. Since the components of the jetting media are the same as the adhered objects, there is no additional new adhering of the foreign objects to the jig even if jetting media remains on the jig, and effects on the coated film can be reduced when the jig is used to deposit a film. To be described as having "approximately the same material" it is sufficient for at least components other than unavoidable impurities to be the same; composition ratios may differ if the effects thereof on the coating permit.

0025 In one embodiment, the outer shape of the jetting media may be formed as a convex curved surface. Adhesion of metal components to the surface due to friction with the processing device can be suppressed, and leaving of residual metal components on the jig can be further minimized. Collision force is dispersed when colliding with the jig, thus reducing damage to the jig.

0026 In one embodiment, the average grain size of the jetting media may be within the range of 50 µm to 400 µm. Collision energy can be efficiently applied to the crystal grain boundary, therefore adhered objects can be efficiently removed.

0027 One embodiment may further include the following steps.
- a step for heating a jig to which adhered objects are adhered;
- a second jetting step for jetting the jig with jetting media after it has been heated.

0028 A film deposition apparatus is set so that optimal conditions obtain at the base material loading portion where film is formed. Therefore deposition may not be achieved in a normal state due to excess insufficiency of temperature in positions separated from the base material loading portion (e.g., a wafer pocket when the base material is a wafer). I.e., in positions separated from the base material loading portion, adhered objects can adhere when no crystal grain boundary is present. In this case, adhered objects on the entire jig can be removed by additional performance of the above heating step and second jetting step.

0029 In one embodiment, the temperature for heating the jig in the heating step may be within the range of 500°C to 1000°C. Adhered objects can be efficiently removed from the entire jig without adding excessive energy.

0030 In one embodiment, the jig may be formed of quartz glass. When a jig is formed of quartz glass, the jig receives major damage when, as in the conventional art, the adhered object removal method is to collide hard abrasive grains to cut the adhered objects, but with the embodied adhered object removal method, damage can be kept to an extremely low level.

0031 In one embodiment, the deposition process may also be a metal organic chemical vapor deposition method (MOCVD method). A hard coating of GaN, AIN, or the like is frequently formed when the metal organic chemical vapor deposition method (MOCVD method) is used. This coating differs greatly in hardness from that of jigs such as a tray, susceptor, or opposing plate, therefore great damage is done to jigs when treatment is performed under conditions allowing adhered object removal by conventional adhered object removal methods, whereby the adhered objects are ground off by collision by hard abrasive grains. Using the adhered object removal method in one embodiment, damage to jigs can be reduced and hard adhered objects can be removed efficiently even if a jig is used for the metal organic chemical vapor deposition method (MOCVD method).

### Effect of the Invention

0032 Using one aspect of the present invention, and one embodiment, an adhered object removal method can be provided which is capable of reducing damage to jigs and of removing hard adhered objects.

### Brief Description of Figures

0033
Fig. 1: A schematic explaining a processing apparatus used in an embodiment.
Fig. 2: A flow chart showing the adhered object removal method of the embodiment.
Fig. 3: A schematic diagram explaining the travel path of a workpiece in the embodiment.
Fig. 4: A SEM photograph showing the appearance when adhered objects are removed.
Fig. 5: A SEM photograph comparing removal of adhered objects by the adhered object removal method of the embodiment with removal of adhered objects by conventional art.
Fig. 6: A photograph explaining the case where a step is provided in the adhered object removal method of the embodiment to heat the workpiece.

### Embodiments of the Invention

0034 Referring to figures, we explain an embodiment of the adhered object removal method according to the present invention. Changes, modifications, and improvements may be applied without limitation to this embodiment of the invention so long as they do not deviate from the scope of the claims. Also, unless otherwise noted, the left, right, up, and down directions in the explanation refer to directions in the figures.

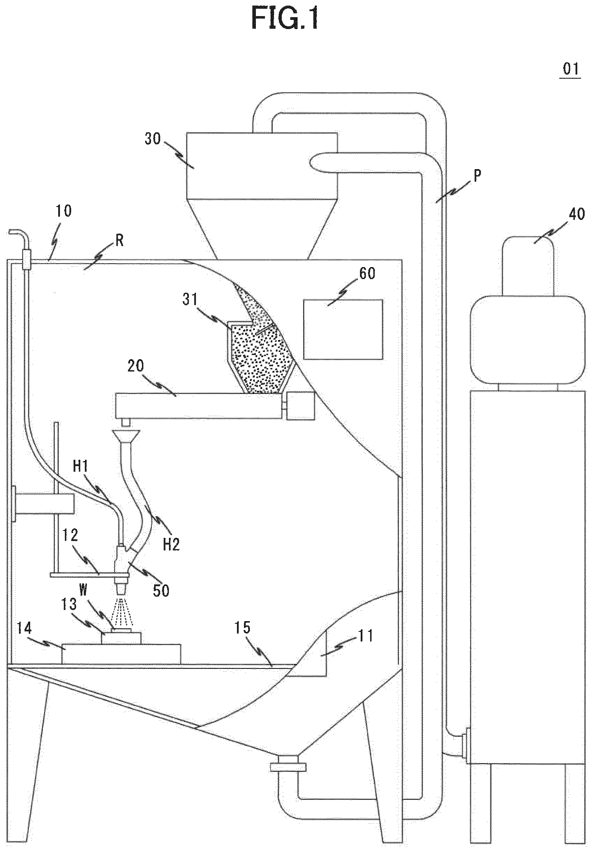

0035 Fig. 1 shows the processing apparatus 01 used in the present embodiment. The processing apparatus 01 comprises: an enclosure 10, a volumetric supply mechanism 20, a separator mechanism 30, a suction mechanism 40, a nozzle 50, and a control mechanism 60.

0036 A processing chamber R is formed on the interior of the enclosure 10; an operator gains access to the processing chamber R by opening a door 11 disposed on the front face thereof. A nozzle affixing jig 12 for affixing the nozzle, a processing table 13 opposing the nozzle for loading a workpiece W (a jig to which adhered objects are adhered), and a transport mechanism 14 linked to the processing table 13 are disposed in the processing chamber R.

0037 The nozzle affixing jig 12 is configured so that the distance between the nozzle 50 and the workpiece W can be freely adjusted.

0038 The transport mechanism 14 is a mechanism for freely moving the processing table 13 (i.e., the workpiece W) in a horizontal direction (the left-right direction in Fig. 1; the vertical direction relative to the paper surface) relative to the nozzle. For example, an appropriate known mechanism such as an X-Y stage may be selected.

0039 The discharge opening 15 is affixed to a stand 15 disposed at the bottom of the nozzle 50. In this embodiment, it is a panel with a large number of holes. Grain bodies jetted from the nozzle 50 are able to pass through toward the bottom portion.

0040 The volumetric supply mechanism 20 is not particularly limited with respect to structure so long as it is capable of dispensing jetting media in fixed quantities. For example, it may be a screw feeder, a vibration feeder, or a table feeder. In this embodiment a screw feeder was used.

0041 The volumetric supply mechanism 20 is linked to a storage hopper 31 linked to the separator mechanism 30. The separator mechanism 30 is linked to the bottom portion of the enclosure 10 through a transport pipe P, therefore the processing chamber R and the storage hopper form a space linked through the transport pipe P. In this embodiment we used a cyclone-type sorter as the separator mechanism 30, but air-type sorters or screen-type sorters may also be used.

0042 Suction and direct pressure-type nozzles are known nozzles for jetting particles; either of these may be selected. In the present embodiment we selected a suction-type nozzle. The nozzle 50 of the present embodiment comprises a nozzle holder and an air nozzle into which this nozzle holder is inserted. The air nozzle is linked to a compressor (not shown) through the air hose H1, and the nozzle holder is connected to the storage hopper 31 through a jetting media hose H2. Jetting media is drawn into the nozzle by the negative pressure arising inside the nozzle holder as a result of operating a compressor to jet compressed air from the nozzle; this is then mixed on the inside thereof and jetted as a solid/vapor two phase flow.

0043 The control mechanism 60 controls all the aforementioned structures. Various types of computing devices such as personal computers, motion controllers such as programmable logic controllers (PLCs) and digital signal processors (DSPs), and multifunction portable terminals or high functioning cell phones or the like may be used as the control mechanism.

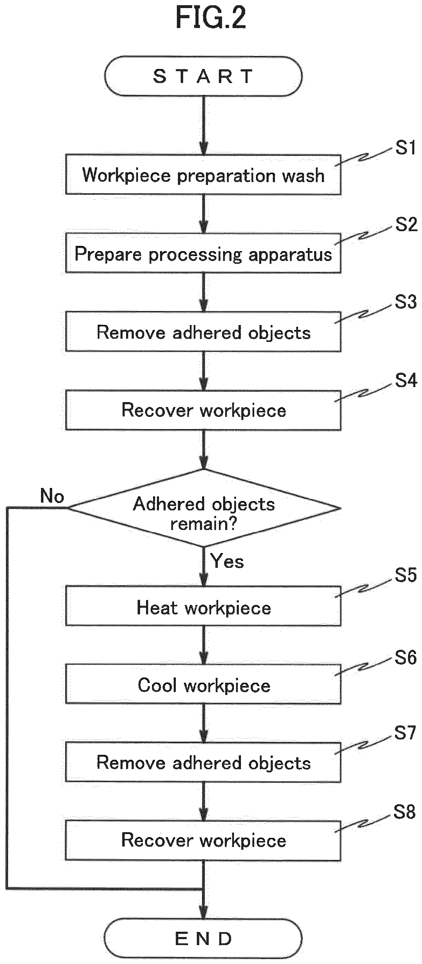

0044 Next, again referring to Fig. 2, we explain an adhered object removal method using the processing apparatus 01 of the present embodiment. The adhered object removal method of the present invention can be applied to remove hard adhered objects adhered to a jig in a crystal growth deposition process. It is particularly effective when objects are adhered to jigs made of easily damaged materials. In the present embodiment we explain a method for removing adhered objects adhering to a jig used when depositing a film using the metal organic chemical vapor deposition method (MOCVD method).

0045 In the structure of a semiconductor device using the MOCVD method, a hard coating of GaN or AIN is formed on the substrate. In more detail, fine crystals of GaN or AIN or the like are formed on the substrate, and a polycrystal coating is formed by the growth of those crystals. At such times, these hard coatings are also formed on jigs such as a tray, a receptor, or an opposing plate. I.e., the adhered objects on the jig is this hard coating film, and a crystal grain boundary is present in these adhered objects. Trays, receptors, and opposing plates are sometimes made up of quartz glass. In this case, there is a large grain size difference relative to the adhered objects, and hard adhered objects are present on the surface of the easily-damaged jig. I.e., when adhered objects are processed under conditions allowing their removal in an adhered object removal method whereby adhered objects are ground off by collisions by hard abrasive grains, as in the conventional art, the jig receives major damage.

0046

### S1: Workpiece prewash

Adhered objects adhering by a relatively weak adhesion force may be removed in advance by a brush or the like. This step may also be omitted.

0047

### S2: Preparing the processing apparatus

The suction mechanism 40 is operated to suction the processing chamber R. Next, the lock on door 11 is released and the door 11 is opened. Next, a certain amount of jetting media is introduced into the processing chamber R and jetting media is transported to the volumetric supply mechanism 20 through the transport pipe P and the separator mechanism 30. The door 11 is then closed and locked. The processing chamber R is suctioned by the suction mechanism 40 and is therefore at a negative pressure, so that outside air flows into the processing chamber R through suction holes (not shown) disposed to communicate with the outside.

0048 As a preparatory step, angular jetting media with corner portions was prepared. Then, taking into account damage to the jig arising from collision of the jetting media, a jetting media softer than the jig was prepared. The hardness of the jetting media may be 1/2 or less the hardness of the jig.

0049 When jig hardness (Vickers hardness as specified in JIS Z2244: 2009 or JIS R1610: 2003 (ISO 6507)) is HV100 to HV918, the hardness of the jetting media (Rockwell hardness specified in JIS K7202: 2001 (ISO 6508)) may be R15 to R125 or M20 to M125. Examples of materials satisfying these specifications include, for jigs: stainless steel, aluminum, titanium, glass, quartz glass and the like, and for jetting media: glass, melamine resin, urea resin, unsaturated polyester, sodium bicarbonate, nylon, dry ice, walnut shells, peach pits, apricot pits, and the like.

0050 When a jig is formed of compound materials, there is a potential that coating layers will be ground off or peel upon impact by the jetting media, depending on coating layer thickness, coating layer shape, and the like. If there are defects such as cracks or pinholes in the base material, those cracks may give rise to coating layer fractures when the jetting media makes impact. In light of this, a jet media collision energy of 1.0 × 10⁻⁹J to 1.0 × 10⁻⁸J may be used when selecting material with a relatively high rigidity as the jetting media. As a jetting media with relatively high rigidity, a material with a Young's modulus, as specified in JIS R1602: 1995, of 50 GPa or greater may be selected, and a 100 GPa to 800 GPa material may be selected. Examples of such material include various ceramic materials such as quartz glass, alumina, aluminum nitride, silicon carbide, silicon nitride, and the like.

0051 In all types of jigs, the jetting media remains on the jig, so in some cases coating performance declines due to components originating from the jetting media when film is deposited using the jig. Material can be selected so as not to adversely affect the post-deposition coating even if jetting media remains on the jig. For example, if the jetting media and coating are approximately the same material, then even if jetting media does remain on the jig, the remaining components will have the same materials as the coating. Therefore even if components originating in the jetting media are mixed in during depositions using this jig, those components are of the same material as the coating, so effects on coating performance can be reduced.

0052 As discussed below, it is necessary to know the mass of the jetting media. For this purpose, grains with known true specific gravity may be used, or true specific gravity can be measured in advance by known methods such as the pycnometer method.

0053 The control mechanism 60 on the processing apparatus 01 is operated to turn the electromagnetic valve disposed on the path supplying pressurized air to the nozzle 50 to "OPEN," and the volumetric supply mechanism 20 to "ON." This action causes jetting media to be supplied to the nozzle 50 and jetted from the nozzle 50. Here the quantity of jetting media is adjusted, but there is no particular limitation regarding this adjustment method. For example, the correlation between jetting media physical properties (type, grain size, etc.), jetting pressure, and jetting velocity can be measured in advance and, based on these results, the jetting pressure can be adjusted to achieve the desired jetting velocity. In this embodiment, the relationship of jetting pressure and jetting velocity to physical properties of the jetting media are first measured using Particle Image Velocimetry (PIV), then a compressed air supply pressure adjustment valve (not shown) is operated to adjust so that the jetting media jetting velocity is at the desired velocity.

0054 After adjusting the jetting velocity, the processing apparatus 01 control mechanism 60 is operated to respectively switch the above-described electromagnetic valve to "CLOSED" and the volumetric supply mechanism 20 to "OFF." This operation stops jetting of the jetting media. The door 11 is opened and the workpiece W is loaded on the processing table 13 and fixed in place. The distance between the nozzle 50 and the workpiece W is then adjusted using the affixing jig 12. When all this work is completed, the door 11 is closed and locked.

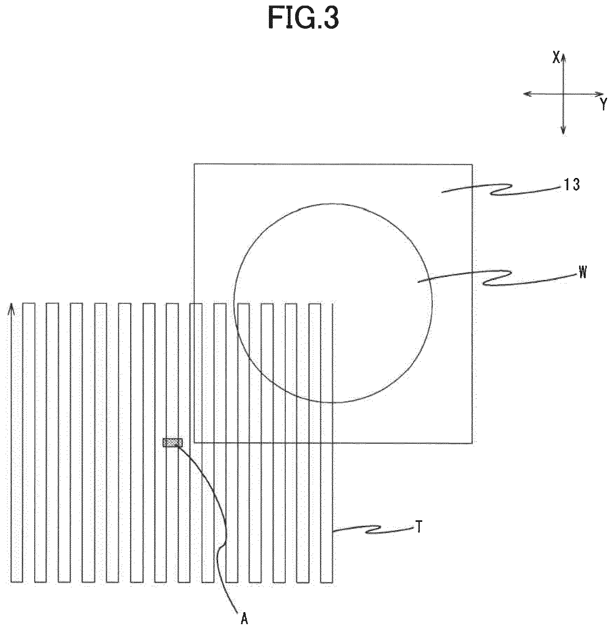

0055 Processing conditions such as workpiece W motion trajectory (X and Y direction distances in Fig. 3), motion speed, and number of sweeps are input into the control mechanism 60.

0056

### S3: Adhered object removal

In the jetting step, the processing apparatus 01 control mechanism 60 is operated to turn the above-described electromagnetic valve to "OPEN" and the volumetric supply mechanism 20 to "ON," resulting in jetting of jetting media. Next, the transport mechanism 14 is turned to "ON" and the workpiece W is moved horizontally relative to the nozzle. For example, the sweep trajectory of the center C of the workpiece W shown in Fig. 3 is one which repeatedly sweeps from the end of the workpiece W into the jetting media jetting area A in the X direction, then offsets by a predetermined pitch in the Y direction, then returns in the X direction, in a comb tooth pattern. By moving the workpiece W in this way relative to the nozzle, jetting media can be collided with the entire surface of the workpiece. Here, when the nozzle 50 jetting port is formed as a rectangle, the jetting width for jetting media in a single X direction sweep can be increased by arranging so that the long side of the port is in the Y direction to improve jetting treatment efficiency.

0057 When the jig is moved down to the bottom of the nozzle 50 jetting port, the jetting media collides with the workpiece. At the start of the collision, starting points for fracture are formed at the crystal interface by the corner portions of the jetting media. Further collisions by the jetting media cause crystal grains to peel off at those starting points.

0058 Here a lower jetting media hardness is more advantageous from the standpoint to the jig, but if hardness is too low, the ability to form starting points for fracture of the crystal interface is insufficient. While there are advantages to high hardness, such as shorter working time and easy cleaning in subsequent steps due to low residual jetting media on the jig after working, damage to workpieces is great when hardness is too high.

0059 When collision energy upon the impact of jetting media with the workpiece W is too small, the ability to form fracture starting points at crystal interfaces is insufficient, and when too high, adhered objects are removed, but damage to the workpiece is great. In order to remove adhered objects with little damage to the workpiece W and with good efficiency, the jet media collision energy may be 1.4 × 10⁻⁷J to 5.4 × 10⁻⁴J. Also, to remove adhered objects effectively while minimizing damage to the workpiece W, a jet media collision energy of 1.0 × 10⁻⁶J to 1.0 × 10⁻⁴J is desirable. Jetting media collision energy can be calculated by the expression "1/2 × m × v²," where m is the jetting media mass and v is the jetting media velocity. The jetting media mass may also be calculated by first calculating a volume by approximating the jetting media as a sphere using its average diameter, then multiplying by specific gravity ρ.

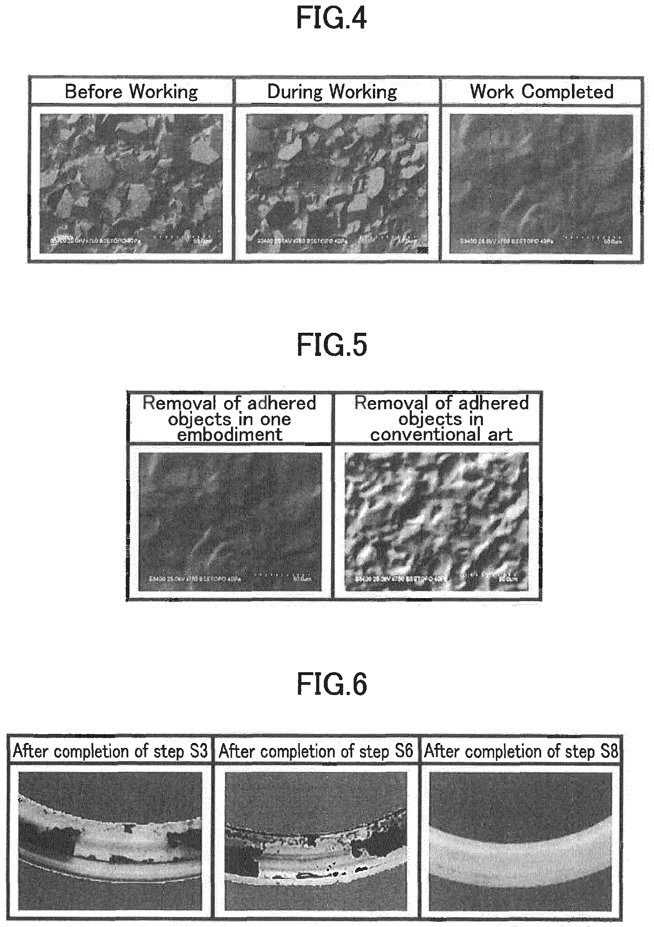

0060 The appearance of peeling at the crystal interface is shown in the SEM micrograph in Fig. 4. It will be seen that prior to working, crystal grains in the surface are observed, but in the depth direction crystals precisely stack up for form a coating ("Prior to Working" in the figure). It can be seen that this work in the present embodiment results in peeling of the coating at the crystal grain boundary ("During Working" in the figure). Thereafter, adhered objects are completely removed from the jig surface ("After Working" in the figure). Here it is presumed that the surface roughness is from damage received by the jig when depositing films. Adhered objects were removed with chemicals and the jig surface was observed by SEM; the same kind of roughness was confirmed to have formed.

0061 Fig. 5 shows SEM micrographs comparing the results of removing adhered objects by the method of the present embodiment and of removing adhered objects by a conventional art method (collide with hard abrasive grain to remove adhered objects). It is observed that with the conventional method, the jig surface is ground by the jetting media. Also, it was confirmed by measurement with an integrated surface roughness and profilometer that when removing adhered objects by the conventional method, the jig surface is ground by the jetting media. Therefore using the method of the present embodiment, adhered objects can be removed with minimal damage to the jig.

0062 Powder dust (removed adhered objects or jetting media diminished to an non-reusable size) produced by the jetting media and by working is transported to the separator mechanism 30 by the suction force of the suction mechanism 40. In the separator mechanism 30, reusable jetting media (No. 1) is separated from dust, and non-reusable jetting media (No. 1) is piled up in a storage hopper 31. The non-reusable jetting media (first) accumulated in the storage hopper 31 is transported to the nozzle 50 and re-jetted. In the meantime, light weight dust is suctioned into the suction mechanism 40 and captured by collection filters installed on the interior of the suction mechanism 40.

0063

### S4: Workpiece recovery

After the specified work is completed, a control means is used to respectively switch the transport mechanism 14 to "OFF," the above-described electromagnetic valve to "CLOSED," and the volumetric supply mechanism 20 to "OFF." Thereafter the door 11 is unlocked, the door 11 is opened, and the workpiece W is recovered. Jetting media or dust adhering to the workpiece W are removed by blowing air or by ultrasonic cleaning or the like, and the series of work steps is complete.

0064 It can occur that adhered objects remain on a workpiece, in locations far from the workpiece W base material loading portions, even if the workpiece has passed through S1-S3. This is speculated to be either because crystals bond strongly to one another in the residue of adhered objects, or that there is no crystal grain boundary. When adhered object residue is present, it is also acceptable to additionally perform steps S5-S8 below. When there is no residual adhered object, these steps may of course be omitted.

0065

### S5: Heat workpiece

An isothermal vessel kept at a specified temperature on its interior is prepared; as a heating step, the workpiece is placed on the inside thereof and heated. Because the coefficients of thermal expansion differ between the jig and the adhered objects, the tight adhesion force between the jig and the adhered objects drops when heated to a specified temperature. It is sufficient to reduce the adhesion force to the level where adhered objects can be removed in the S7 step described below; excessive heating leads to energy losses. Also, jig life is reduced by imparting thermal damage to the jig by heating it to the vicinity of the jig's softening temperature, for example. The heating temperature may be 500°C to 1000°C, or may also be 800-1000°C.

0066

### S6: Workpiece cooling

The workpiece is cooled to room temperature. If cooling is fast, fine cracks form in the adhered objects, so although the adhered objects can be easily removed in the later S7 step, the jig is also thermally damaged. A cooling speed is determined so that adhered objects can be easily removed in the S7 step, but there is no thermal damage to the jig. So long as these two aspects are satisfied, cooling can also be accomplished by leaving the workpiece in a room.

0067

### S7: Adhered object removal

As a second jetting step, the jetting media is jetted toward the workpiece W by performing the same operations as in steps S1-S3. As described above, when a jetting media softer than the jig is used, damage to the jig can be limited, but it is also acceptable to use the same jetting media as was used in the S3 step. The adhesive strength of the adhered objects to the jig is reduced by heating, and because of its hard and brittle nature, cracks in adhered objects occur from collisions with the jetting media, and adhered objects are removed, with these cracks serving as starting points.

0068

### S8: Workpiece recovery

The workpiece W is recovered by the same operation as the S4 step; jetting media and dust, etc. adhering to the workpiece are removed by air blowing or by an ultrasonic cleaner or the like, and this sequence of work is completed.

0069 Results of the adhered object removal performed in steps S05-S08 are shown in Fig. 6. The left diagram shows the appearance of adhered objects remaining on a workpiece W which has passed through steps S1-S4. The middle figure shows the workpiece after it has been heated then cooled (S5, S6). It can be seen that adhered objects are not removed by heating and cooling alone. The right figure shows the condition after jetting media has been jetted onto a workpiece W subjected to this heating and cooling (S7, S8). This shows that adhered objects on the entire workpiece W can be removed by passing through steps S5-S8.

0070 Next we explain results of removing adhered objects from the workpiece by the adhered object removal method of the first embodiment of the invention.

0071 Taking into account the actual jig usage environment, we prepared as a jig-equivalent base material the piece shown below, in which two types of base material were held for 10 minutes at 1000°C, then cooled to room temperature, and this cycle was repeated 200 times. (Unless otherwise noted, base material A and base material B are referred to collectively below as "virtual jig").
Base material A: Quartz plate (2 inches, or 50.8 mm, × 1.0 mm thick; Vickers hardness Hv714 to Hv918)
Base material B: a plate of compound materials. A carbon plate on which an SiC coating layer (thickness: 120 µm) is formed (2 inches, or 50.8 mm, × 1.0 mm thick; coating layer Vickers hardness Hv 2200).

0072 The nozzle was arranged so the distance between the nozzle and the workpiece was 100 mm, and the angle of the jetting flow relative to the workpiece 90°. Jetting media was then jetted for 5 minutes to a fixed point on the workpiece.

0073 After working, the cutting depth (loss) on the virtual jig was confirmed using an integrated surface roughness/profilometer. Evaluation criteria were as follows.
Base Material Loss Evaluation
∘: cutting depth is less than 3 µm
△: cutting depth is 3 µm-5 µm
x: cutting depth exceeds 5 µm

0074 For conditions in which the "Base Material Loss Evaluation" result was either a o or a △, further removal of adhered objects was performed. A film-forming operation was repeated 10 times using the MOCVD method to form a 50 µm thick coating on a virtual jig to which the preceding processing had been applied. This film was GaN relative to base material A and AIN relative to base material B.

0075 In the same manner as described above, an adhered object (coating) was removed by jetting with jetting media for 5 minutes to a fixed point on a virtual jig on which a film was formed.

0076 After working, removal of the adhered objects was confirmed by microscope observation and by EDX analysis.
Evaluation of Adhered Object Removal
∘: No residual film confirmed by EDX.
△: No residual film confirmed by eye, but a slight residual film confirmed by EDX.
x: Residual film confirmed by eye.

0077 Results are shown in Table 1. In tests 7-9, 12-14, and 17-19, in which the hardness (Rockwell hardness) of the jetting media relative to base material A was in a range of R15 to R125 or M20 to M125, and adhered object removal was performed at a collision energy of 1.4 × 10⁻⁷J to 5.4 × 10⁻⁴J, each evaluation result was a ∘, and it was shown that adhered objects could be favorably removed. Note that of the test results shown in Fig. 1, those for which the "Base Material Loss Evaluation" or "Adhered Object Removal Evaluation" has an "x" are not from the embodiment of the invention.

0078 Tests 1-6, 10, 11, 15, 16, and 20-25, in which the jetting media hardness and/or collision energy is outside the range above, were evaluations in which at least one of the "Base Material Loss Evaluation" or the "Adhered Object Removal Evaluation" was a △ or an x. Of these, from a practical standpoint, a △ evaluation means there is a non-problematic decline in attributes, but a decline in workpiece attributes was observed compared to work performed within the above-noted range of jetting media hardness and collision energies.

0079 A coating was similarly removed under test 25 conditions and the worked surface of the virtual jig observed by SEM. For comparison, the worked surfaces of the virtual jig were observed by SEM after being treated in test 13 and test 21. Results thereof are as follows.

Test 13: Attributes as shown in the left diagram in Fig. 5; removal accomplished by separation starting at the crystal grain boundary.

Test 21: Attributes as shown in the left diagram in Fig. 5; removal accomplished by separation starting at the crystal grain boundary. However, traces of partial surface roughening on the surface were observed, and this is assumed to have caused the degradation in workpiece attributes.

Test 25: Attributes as shown in the right diagram in Fig. 5, wherein the film was cut away and removed.

0080 In tests 26 and 27, in which the jetting media hardness relative to base material B was 1/2 or less that of the base material B, and adhered object removal was performed at a collision energy in a range of 1.0 × 10⁻⁹J to 1.0 × 10⁻⁸J, each evaluation result was a ∘, and it was shown that adhered objects could be favorably removed.

0081 Using these ceramic particles as the jetting media, in tests 28 and 29, where the collision energy was outside the above range, at least one of the "Base Material Loss" or "Film Removal" evaluations was either a △ or an x. Of these, from a practical standpoint, a △ evaluation means there is a non-problematic decline in attributes, but compared to work performed within the above range of jetting media hardness and collision energy, a decline in workpiece attributes was observed.

0082 Using a resin material as a low rigidity jetting media in test 30, in which adhered objects were removed within the above collision energy range, the "Base Material Evaluation" was a o, but the film removal evaluation was an x. We assume this is because jetting media rigidity was low, so even though jetting media collided, it was not possible to form fracture starting points at the crystal grain boundary. In test 31, in which, using the same jetting media, the collision energy was increased to remove adhered objects, the "Base Material Loss" evaluation was an x. It was confirmed that the cause for this was defects present in the mother material causing fracturing of the coating layer, and furthermore that the base material itself was damaged, with these defects acting as starting points.

0083 The above results suggest the following.
(1) To reduce damage to the base material (jig) and remove adhered objects, it is good to peel off the adhered objects starting from the crystal grain boundary.
(2) For removing adhered objects efficiently, the balance between the hardness of jetting media relative to the jig, and the collision energy when jetting media collides with the jig, is important.

0084

**Table 1**

| | Condition | | | Result | |
|---|---|---|---|---|---|
| | Base Material | Hardness | Collision Energy (J) | Base Material Loss | Film Removal |
| Test 1 | A | HRR85 | 3.0×10⁻⁸ | ○ | × |
| Test 2 | A | HRR85 | 4.7×10⁻⁷ | ○ | Δ |
| Test 3 | A | HRR85 | 7.9×10⁻⁶ | ○ | Δ |
| Test 4 | A | HRR85 | 1.2×10⁻⁴ | ○ | Δ |
| Test 5 | A | HRR85 | 1.9×10⁻⁴ | × | - |
| Test 6 | A | HRR110 | 9.3×10⁻⁸ | ○ | × |
| Test 7 | A | HRR110 | 1.4×10⁷ | ○ | ○ |
| Test 8 | A | HRR110 | 5.7×10⁻⁶ | ○ | ○ |
| Test 9 | A | HRR110 | 5.4×10⁻⁴ | ○ | ○ |
| Test 10 | A | HRR110 | 8.4×10⁻⁴ | × | - |
| Test 11 | A | HRM100 | 9.3×10⁻⁸ | ○ | Δ |
| Test 12 | A | HRM100 | 1.4×10⁻⁷ | ○ | ○ |
| Test 13 | A | HRM100 | 5.7×10⁻⁶ | ○ | ○ |
| Test 14 | A | HRM100 | 5.4×10⁻⁴ | ○ | ○ |
| Test 15 | A | HRM100 | 8.4×10⁻⁴ | Δ | ○ |
| Test 16 | A | HRM125 | 9.3×10⁻⁸ | Δ | ○ |
| Test 17 | A | HRM125 | 1.4×10⁻⁷ | ○ | ○ |
| Test 18 | A | HRM125 | 5.7×10⁻⁶ | ○ | ○ |
| Test 19 | A | HRM125 | 5.4×10⁻⁴ | ○ | ○ |
| Test 20 | A | HRM125 | 8.4×10⁻⁴ | × | - |
| Test 21 | A | Hv500 | 4.3×10⁻⁸ | Δ | ○ |
| Test 22 | A | Hv500 | 1.6×10⁻⁷ | × | ○ |
| Test 23 | A | Hv500 | 5.9×10⁻⁶ | × | - |
| Test 24 | A | Hv500 | 5.3×10⁻⁴ | × | - |
| Test 25 | A | Hv500 | 8.9×10⁻⁴ | × | - |
| Test 26 | B | Hv1050 | 1.2×10⁻⁹ | ○ | ○ |
| Test 27 | B | Hv1050 | 9.7×10⁻⁹ | ○ | ○ |
| Test 28 | B | Hv1050 | 9.0×10⁻¹⁰ | ○ | Δ |
| Test 29 | B | Hvl050 | 3.0×10⁻⁸ | Δ | ○ |
| Test 30 | B | HRR85 | 9.7×10⁻⁹ | ○ | × |
| Test 31 | B | HRR85 | 7.9×10⁻⁶ | × | - |

0085 In the first embodiment we explained removal of a film adhered to a surface in which quartz and SiC-coated carbon was selected as the jig-equivalent base material, but the jig material is not limited to these.

0086 Next we explain an adhered object removal method in a second embodiment of the invention.

In the adhered object removal method of this embodiment, the jetting media used to remove adhered objects differs from the above-described first embodiment.

0087 In this embodiment we used a jetting media softer than the jig, so that adhered objects could be efficiently removed while minimizing damage to the jig when the jetting media collides with the jig. At this point the hardness of the jetting media may be 1/2 or less the hardness of the jig. In addition, a material not containing any metal component was used so that no metal component originating in the jetting media would be left on the jig. The injection material may be selected as appropriate to match jig hardness from ceramic (alumina, silicon carbide, zircon, etc.), resin (urea resin, nylon, acrylic resin, phenol resin, etc.), glass, plant seed (walnut shell, peach pit, apricot pit, etc.), or sodium bicarbonate, dry ice, or the like. Of these, resin permits easy adjustment of shape and grain size and can be manufactured at low cost, so is particularly preferred for use. When selecting a resin, at least the outside surface should be resin. I.e., the entirety may be composed of resin, or particles may have resin positioned on the outer shell of a high specific gravity grain as nucleus.

0088 There is no particular limitation on the shape of the jetting media. Adhered material removal efficiency increases when jetting media grains have corners, but there is a risk that components adhering to the surface of the jetting media arising from contact with the processing apparatus 01 will more easily adhere. There are many opportunities for the jetting media to contact the enclosure 10, so there is a possibility that a very tiny amount of an apparatus-origin metal component will adhere to the surface of the jetting media. Therefore to more fully eliminate residual metal components, the jetting media grains may also be formed with rounded convex curved lines on the corners. In such shapes, the collision force is dispersed when colliding with the jig, thus reducing damage to the jig. Forming with a convex curved line can be accomplished with a spherical shape, or by rounding the corner portions of a polygonal shape or an anisotropic shape.

0089 If the grain size of the jetting media is too small, adhered objects cannot be removed; if too large there is damage to the jig. In the present embodiment we adopted an average grain size d50 of 50-400 µm. When such jetting media is used, fracture starting points are formed at the crystal grain boundary at the start of collision by the jetting media collision energy. Further collisions by the jetting media cause crystal grains to peel off at those starting points.

0090 Next, we explain results of removing adhered objects from the workpiece by the adhered object removal method of a second embodiment of the invention.

0091 As a jig-equivalent base material, taking into account the actual jig usage environment, we prepared a quartz plate (2 inches, or 50.8 mm, × 1.0 mm thick; Vickers hardness HV714-918); this was held at 1000°C for 10 minutes, then cooled to room temperature; this cycle was repeated 200 times.

0092 The nozzle was arranged so the distance between the nozzle and the workpiece was 100 mm, and the angle of the jetting flow relative to the workpiece is 90°. Jetting media was then jetted for 5 minutes to a fixed point on the workpiece. The following were used as jetting media.
Jetting media A: urea resin (Rockwell hardness HRM = 15; polygonal)
Jetting media B: Nylon resin (Rockwell hardness HRR = 110; cylindrical)
Jetting media C: acrylic resin (Rockwell hardness HRM = 95; spherical)
Jetting media D: phenol resin (Rockwell hardness HRM = 125; spherical)
Jetting media E: glass (Vickers hardness HV = 500; spherical)
Jetting media F: walnuts (Mohs hardness = 2; polygonal)
Jetting media G: white fused alumina (Vickers hardness HV = 2200; polygonal)
Jetting media H: grain on which a white fused alumina grain is supported on the outer edge of urethane rubber (Shore A hardness = 40; columnar)
Jetting media I: stainless steel (Vickers hardness Hv = 187; spherical)

0093 After working, the cutting depth (loss) on the quartz plate was confirmed using an integrated surface roughness/profilometer. Evaluation criteria were the same as in the first embodiment.

For conditions in which the "Base Material Loss Evaluation" result was either a o or a △, further removal of adhered objects was performed. A film-forming operation was repeated 10 times using the MOCVD method to form a 50 µm thick GaN film on the quartz plate to which the preceding processing had been applied.

0094 In the same manner as described above, adhered objects (film) were removed by jetting with jetting media for 5 minutes to a fixed point relative to the quartz plate on which a film was formed.

After working, removal of the adhered objects was confirmed by microscope observation and by EDX analysis. Adhered object removal evaluation criteria were the same as in the first embodiment.

0095 Results are shown in Table 2.

### Base Material Wear Evaluation

Tests 32-42, 44, and 45, in which the jetting media hardness was lower than the quartz plate, were evaluations in which at the base material wear evaluation was a o or a △. △ evaluations mean there is no problem for practical use, or that a o evaluation could be achieved by optimizing processing conditions. On the other hand in tests such as 43, which uses a jetting media with a higher jetting media hardness than quartz plate, the base material wear evaluation was an x, even when the jetting media collision energy was excessively lowered. Note that test 43 is not an embodiment of the invention. It was thus shown that damage to the base material can be minimized by using jetting media with a lower hardness than the jig.

0096 When tests 32, 38, and 39 were compared in order to investigate the effect of jetting media shape on damage to the base material, a o was assigned for all qualitative evaluations, but the deepest cutting remained in test 39, which used a spherical jetting media. It was therefore shown that damage to the base material can be minimized by using a jetting media on which convex curved surfaces are formed over the entire grain.

0097

### Evaluation of Adhered Object Removal

The results of removing the coating under the conditions of tests 32-42 and 44-45, in which the base material loss evaluation was a o or a △, were in all cases a o or a △. △ evaluations mean there is no problem for practical use, or that a o evaluation could be achieved by optimizing processing conditions. Tests 32-42 and 44-45 fall within the jetting media collision energy range of 1.0 × 10⁻⁶J to 1.0 × 10⁻⁴J. Therefore it was shown that under these conditions the coating can be sufficiently peeled off.

0098

### Metal Component Residue Evaluation

After removing adhered objects from an actual jig (quartz) under test conditions 38, 44, and 45, a GaN coating was formed on a substrate by the MOCVD method on a substrate using that jig. After forming the coating, the component depth was analyzed in the GaN coating depth direction by TOF-SIMS. As a result, no metal component was detected for test 38, Al was detected in test 44, and Fe was detected in test 45. It appears the detected Al originates in the alumina supported on the outer edge of the urethane rubber, and the Fe originates in stainless steel. I.e., the jetting media metal component appears to remain on the jig, and penetrates into the GaN coating. For example, when an LED light emitting-element is formed using MOCVD, the metal component remaining on the jig leads to reduced performance of the deposited film, such as reduced light emitting efficiency. Therefore parts containing a metal component in the jetting media are not well suited for such purposes.

0099 The above results suggest the following.
(1) To remove adhered objects with reduced damage to the base material (jig), it is desirable to use jetting media with a lower hardness than the jig, and not containing a metal component.
(2) For removing adhered objects efficiently, the balance between the hardness of jetting media relative to the jig and the collision energy when jetting media collides with the jig is important.

0100

**Table 2**

| No. | Condition | | | Result | |
|---|---|---|---|---|---|
| | Jetting Media | Grain size(µm) | Collision Energy (J) | Base Material Damage | Adhered Object Removal |
| Test 32 | A | 380 | 537×10⁻⁵ | ○ | ○ |
| Test 33 | A | 380 | 9.07×10⁻⁵ | ○ | ○ |
| Test 34 | A | 380 | 1.37×10⁻⁴ | ○ | ○ |
| Test 35 | A | 250 | 1.53×10⁻⁵ | ○ | ○ |
| Test 36 | A | 180 | 5.71×10⁻⁶ | ○ | ○ |
| Test 37 | A | 125 | 1.91×10⁻⁶ | ○ | Δ |
| Test 38 | B | 400 | 4.73×10⁻⁵ | ○ | ○ |
| Test 39 | C | 300 | 2.09×10⁻⁵ | ○ | ○ |
| Test 40 | D | 300 | 8.01×10⁻⁵ | ○ | ○ |
| Test 41 | E | 77 | 1.87×10⁻⁶ | Δ | ○ |
| Test 42 | F | 300 | 5.79×10⁻⁵ | ○ | Δ |
| Test 43 | G | 30 | 6.89×10⁻⁸ | × | not tested |
| Test 44 | H | 300 | 2.12×10⁻⁵ | ○ | ○ |
| Test 45 | I | 275 | 1.08×10⁻⁴ | ○ | ○ |

0101 In one embodiment we explained that quartz was selected as the jig-equivalent base material and a coating adhered to the surface thereof was removed, but the jig material is not limited to quartz.

0102 In one embodiment we explained the removal of adhered objects from a jig used when depositing film by the MOCVD method, but adhered objects can be removed from jigs used in film deposition processes for all types of crystal growth, including physical vapor phase deposition methods (PVD) such as vacuum deposition and sputtering, and chemical vapor phase deposition methods (CVD) such as CVD and plasma CVD.

0103 In one embodiment we explained the film deposition process in the context of the process for manufacturing a semiconductor device, but the method may be applied to removal of adhered objects from jigs used in film deposition processes using thin film crystal growth for other manufacturing processes, such as the manufacture of fixtures and tools.

### Explanation of Reference Numerals

0104
01: processing apparatus
10: enclosure
11: door
12: nozzle affixing jig
13: processing table
14: transport mechanism
15: stand
20: volumetric supply mechanism
30: separator mechanism
31: storage hopper
40: suction mechanism
50: nozzle
60: control mechanism
A: jetting area
H1: air hose
H2: jetting media hose
R: processing chamber
T: sweep trajectory
W: workpiece

## Claims

1. An adhered object removal method for removing adhered objects from jig used in film deposition processes accomplished by thin film crystal growth, comprising:
preparing a jetting media having a lower hardness than the hardness of the jig; and
jetting the jetting media toward the jig,
whereby in the jetting, the jetting media forms fracture starting points at a crystal grain boundary of the adhered object when the jetting media collides with the jig, and the jetting media collides with the fracture starting points and causes the adhered objects to dislodge at the crystal grain boundary,
whereby the jetting media does not contain a metal component, and adhered objects are removed by collision energy when the jetting media jetted toward the jig collides with the jig, and
wherein at least a surface layer of the jetting media is comprised of resin.

2. The adhered object removal method of Claim 1, wherein the jetting media hardness is 1/2 or less the jig hardness.

3. The adhered object removal method of Claim 1 or 2, wherein the adhered objects are harder than the jig.

4. The adhered object removal method of any one of Claims 1 through 3, wherein the jig has a Vickers hardness within a range of Hv100 to Hv918, and the jetting media has a Rockwell hardness within a range of R15 to R125 or a range of M20 to M125 and is collided with the jig at a collision energy within a range of 1.4 × 10⁻⁷J to 5.4 × 10⁻⁴J.

5. The adhered object removal method of any one of Claims 1 through 3, wherein the jig has a ceramic coating layer, and the jetting media has a Young's modulus of 50GPa or greater and is collided with the jig at a collision energy within a range of 1.0 × 10⁻⁹J to 1.0 × 10⁻⁸J.

6. The adhered object removal method of any one of Claims 1 through 5, wherein the jetting media grains have corner portions.

7. The adhered object removal method of Claim 1 or 2, wherein the jetting media is of the same material as the adhered object.

8. The adhered object removal method of Claim 1, wherein an outside shape of the jetting media is formed in a convex curved surface.

9. The adhered object removal method of Claim 8, wherein the jetting media has an average grain size within a range of 50 µm to 400 µm.

10. The adhered object removal method of any one of Claims 1 through 9, further comprising heating the jig to which the adhered objects are adhered, and second jetting with the jetting media toward the heated jig.

11. The adhered object removal method of Claim 10, whereby in the heating, the jig is heated to a temperature within a range of 500°C to 1000°C.

12. The adhered object removal method of any one of Claims 1 through 10, wherein the jig is formed of quartz glass.

13. The adhered object removal method of any one of Claims 1 through 12, wherein the film deposition process is a metal organic chemical vapor deposition method.

## Patentansprüche

1. Ein Verfahren zum Entfernen von anhaftenden Objekten, um anhaftende Objekte von einer Schablone zu entfernen, die in Filmabscheidungsprozessen verwendet wird, die durch Dünnschicht-Kristallwachstum erfolgen, Folgendes umfassend:
Herstellen eines Strahlmittels (*a jetting media),* das eine geringere Härte als die Härte der Schablone aufweist; und
Ausstoßen des Strahlmittels in Richtung der Schablone,
wobei, beim Ausstoßen, das Strahlmittel Bruchausgangspunkte an einer Kristallkorngrenze des anhaftenden Objekts bildet, wenn das Strahlmittel mit der Schablone kollidiert, und wobei das Strahlmittel mit den Bruchausgangspunkten kollidiert und bewirkt, dass sich die anhaftenden Objekte an der Kristallkorngrenze lösen,
wobei das Strahlmittel keine Metallkomponente enthält, und anhaftende Objekte durch die Kollisionsenergie entfernt werden, wenn das in Richtung der Schablone gestrahlte Strahlmittel mit der Schablone kollidiert, und
wobei mindestens eine Oberflächenschicht des Strahlmittels ein Harz umfasst.

2. Das Verfahren zum Entfernen von anhaftenden Objekten nach Anspruch 1, wobei die Härte des Strahlmittels 1/2 oder weniger der Härte der Schablone beträgt.

3. Das Verfahren zum Entfernen von anhaftenden Objekten nach Anspruch 1 oder 2, wobei die anhaftenden Gegenstände härter sind als die Schablone.

4. Das Verfahren zum Entfernen von anhaftenden Objekten nach irgendeinem der Ansprüche 1 bis 3, wobei die Schablone eine Vickershärte im Bereich von Hv100 bis Hv918 aufweist und das Strahlmittel eine Rockwellhärte im Bereich von R15 bis R125 oder im Bereich von M20 bis M125 aufweist und mit einer Kollisionsenergie im Bereich von 1,4 × 10⁻⁷ J bis 5,4 × 10⁻⁴ J mit der Schablone kollidieren gelassen wird.

5. Das Verfahren zum Entfernen von anhaftenden Objekten nach irgendeinem der Ansprüche von 1 bis 3, wobei die Schablone eine keramische Beschichtung aufweist und das Strahlmittel einen Young'schen Modul von 50 GPa oder mehr hat und mit einer Kollisionsenergie innerhalb eines Bereichs von 1,0 × 10⁻⁹ J bis 1,0 × 10⁻⁸ J mit der Schablone kollidieren gelassen wird.

6. Das Verfahren zum Entfernen von anhaftenden Objekten nach irgendeinem der Ansprüche 1 bis 5, wobei die Strahlmittelkörner Eckbereiche aufweisen.

7. Das Verfahren zum Entfernen von anhaftenden Objekten nach Anspruch 1 oder 2, wobei das Strahlmittel aus demselben Material wie der anhaftende Gegenstand besteht.

8. Das Verfahren zum Entfernen von anhaftenden Objekten nach Anspruch 1, wobei die äußere Form des Strahlmittels eine konvex gekrümmte Oberfläche bildet.

9. Das Verfahren zum Entfernen von anhaftenden Objekten nach Anspruch 8, wobei das Strahlmittel eine durchschnittliche Korngröße in einem Bereich von 50 µm bis 400 µm aufweist.

10. Das Verfahren zum Entfernen von anhaftenden Objekten nach irgendeinem der Ansprüche von 1 bis 9, das ferner Folgendes umfasst: ein Erhitzen der Schablone, an der die anhaftenden Gegenstände haften, und ein zweites Ausstoßen mit dem Strahlmittel in Richtung der erhitzten Schablone.

11. Das Verfahren zum Entfernen von anhaftenden Objekten nach Anspruch 10, wobei beim Erhitzen die Schablone auf eine Temperatur im Bereich von 500°C bis 1000°C erhitzt wird.

12. Das Verfahren zum Entfernen von anhaftenden Objekten nach irgendeinem der Ansprüche von 1 bis 10, wobei die Schablone aus Quarzglas hergestellt ist.

13. Das Verfahren zur Entfernung von anhaftenden Objekten nach irgendeinem der Ansprüche von 1 bis 12, wobei der Filmabscheidungsprozess ein metallorganisches chemisches Dampfabscheidungsverfahren ist.

## Revendications

1. Le procédé d'élimination d'objets collés à l'écart d'un gabarit utilisé dans les processus de dépôt de couches réalisés par croissance de cristaux en couches minces, comprenant le fait de :
préparer un moyen de projection présentant une dureté inférieure à celle du gabarit ; et de
projeter les moyens de projection vers le gabarit,
grâce à quoi, pendant la projection, les moyens de projection forment des points de départ de fracture au niveau d'une limite de grain cristallin de l'objet collé lorsque les moyens de projection entre en collision avec le gabarit, et par quoi les moyens de projection entrent en collision avec les points de départ de fracture et provoquent le délogement des objets collés au niveau de la limite de grain cristallin,
grâce à quoi les moyens de projection ne comprennent pas de composant métallique et que les objets collés sont éliminés par l'énergie de collision lorsque les moyens de projection projetés vers le gabarit entrent en collision avec le gabarit, et
sachant qu'au moins une couche de surface des moyens de projection est constituée de résine.

2. Le procédé d'élimination d'objets collés d'après la revendication 1, sachant que la dureté des moyens de projection est égale ou inférieure à 1/2 de la dureté du gabarit.

3. Le procédé d'élimination d'objets collés d'après la revendication 1 ou 2, sachant que les objets collés sont plus durs que le gabarit.

4. Le procédé d'élimination d'objets collés d'après l'une quelconque des revendications de 1 à 3, sachant que le gabarit présente une dureté Vickers comprise dans une plage de Hv100 à Hv9 18, et que les moyens de projection présentent une dureté Rockwell comprise dans une plage de R15 à R125 ou de M20 à M125 et qu'ils sont mis en collision avec le gabarit à une énergie de collision comprise dans une plage de 1,4 × 10⁻⁷ J à 5,4 × 10⁻⁴ J.

5. Le procédé d'élimination d'objets collés d'après l'une quelconque des revendications de 1 à 3, sachant que le gabarit a une couche de revêtement céramique, et que les moyens de projection présentent un module de Young de 50 GPa ou plus et qu'ils sont mis en collision avec le gabarit avec une énergie de collision comprise dans une plage de 1,0 × 10⁻⁹ J à 1,0 × 10⁻⁸ J.

6. Le procédé d'élimination d'objets collés d'après l'une quelconque des revendications de 1 à 5, sachant que les grains de moyens de projection ont des parties en coin.

7. Le procédé d'élimination d'objets collés d'après la revendication 1 ou 2, sachant que les moyens de projection sont du même matériau que l'objet collé.

8. Le procédé d'élimination d'objets collés d'après la revendication 1, sachant qu'une forme extérieure des moyens de projection est formée en surface courbe convexe.

9. Le procédé d'élimination d'objets collés d'après la revendication 8, sachant que les moyens de projection présentent une taille moyenne de grain dans une gamme de 50 µm à 400 µm.

10. Le procédé d'élimination d'objets collés d'après l'une quelconque des revendications de 1 à 9, comprenant en outre le fait de chauffer le gabarit auquel les objets collés sont collés, et de projeter une deuxième fois les moyens de projection vers le gabarit chauffé.

11. Le procédé d'élimination d'objets collés d'après la revendication 10, selon lequel pour le chauffage, le gabarit est chauffé à une température comprise dans une plage de 500°C à 1000°C.

12. Le procédé d'élimination d'objets collés d'après l'une quelconque des revendications de 1 à 10, sachant que le gabarit est formé de verre de quartz.

13. Le procédé d'élimination d'objets collés d'après l'une quelconque des revendications de 1 à 12, sachant que le processus de dépôt de couches est un procédé de dépôt chimique en phase vapeur métallo-organique.
